# FASCICULE DE BREVET EUROPEEN

(11) **EP 2 814 041 B1**
(45) Date de publication et mention de la délivrance du brevet: **29.07.2015**
(21) Numéro de dépôt: 14172188.6
(22) Date de dépôt: 12.06.2014
(51) Int. Cl.: H01B 7/32

(54) **Système pour contrôler l'usure d'un câble électrique**
System zum Kontrollieren des Verschleißes eines Elektrokabels
System for monitoring the wear of an electric cable

(30) Priorité: 14.06.2013 FR 1355523
(43) Date de publication de la demande: 17.12.2014
(73) Titulaire: Commissariat à l'Energie Atomique et aux Energies Alternatives, 75015 Paris (FR)
(72) Inventeur: Despesse, Ghislain, 38340 VOREPPE (FR); Carmona, Mikaël, 38570 Tencin (FR); Leger, Jean-Michel, 38190 Villard Bonnot (FR); Paleologue, Alexandre, 73100 Brison Saint Innocent (FR)
(74) Mandataire: Thibon, Laurent

(56) Documents cités:
- FR-A1- 2 830 941
- US-A1- 2004 160 331

## Description

### Domaine

La présente demande concerne un système permettant de contrôler l'état d'usure d'un câble électrique, et plus particulièrement d'une gaine entourant l'âme du câble.

### Exposé de l'art antérieur

Dans de nombreux systèmes, des câbles électriques destinés à transporter des signaux de données ou d'alimentation sont susceptibles d'être soumis à des contraintes mécaniques ou autres, par exemple des frottements. Avec le temps, ces contraintes peuvent dégrader le câble, et provoquer une défaillance ou un disfonctionnement du système (court-circuit, coupure, etc.).

Dans certains domaines sensibles, par exemple dans le domaine de l'aéronautique, une défaillance liée à l'usure d'un câble électrique n'est généralement pas acceptable. Il convient donc de réparer ou de remplacer régulièrement les câbles, de façon à prévenir d'éventuelles défaillances. US 2004/0160331 A1 décrit un câble comportant un brin de détection d'usure s'étendant sur toute la longueur du câble. Ce brin se trouve sous la gaine et on a besoin d'accès au deuxième extrémité pour monter un boucle pour localiser la zone du câble présentant un début d'usure.

Pour faciliter les opérations de maintenance, il serait souhaitable de pouvoir disposer d'un système permettant de détecter préventivement une usure ou un début de dégradation d'un câble électrique, voire éventuellement de localiser la zone du câble présentant un début d'usure, de façon à pouvoir cibler au plus juste les opérations de réparation ou de remplacement des câbles.

### Résumé

Ainsi, un mode de réalisation prévoit un système comprenant : un câble comportant : une âme adaptée à transporter au moins un signal électrique utile ; une gaine entourant l'âme ; au moins un brin conducteur de détection d'usure noyé dans la gaine et s'étendant sensiblement sur toute la longueur du câble ; et au moins un élément conducteur de référence non connecté au brin de détection d'usure et s'étendant sensiblement sur toute la longueur du câble ; et une unité de contrôle adaptée à mesurer la capacité ou la résistance formée entre le brin de détection d'usure et l'élément conducteur de référence.

Selon un mode de réalisation, l'unité de contrôle est reliée au brin de détection d'usure et à l'élément conducteur de référence uniquement à l'une des extrémités du câble.

Selon un mode de réalisation, l'unité de contrôle est adaptée à déduire de ladite mesure de capacité ou de résistance la présence ou l'absence d'une rupture du brin de détection d'usure.

Selon un mode de réalisation, l'unité de contrôle est en outre adaptée à déduire de la mesure la localisation de la rupture par rapport à l'unité de contrôle.

Selon un mode de réalisation, le câble comprend plusieurs brins conducteurs de détection d'usure noyés dans la gaine, et l'élément conducteur de référence comprend un ou plusieurs des brins de détection d'usure.

Selon un mode de réalisation, l'âme du câble comprend un ou plusieurs brins conducteurs adaptés à transporter des signaux électriques utiles, et l'élément conducteur de référence comprend un ou plusieurs des brins de l'âme du câble.

Selon un mode de réalisation, le brin de détection d'usure est sensiblement parallèle à l'âme du câble.

Selon un mode de réalisation, le brin de détection d'usure est torsadé autour de l'âme du câble.

Selon un mode de réalisation, le câble comprend plusieurs brins de détection d'usure disposés à plusieurs profondeurs distinctes dans la gaine.

Selon un mode de réalisation, l'unité de contrôle comprend un microcontrôleur.

Selon un mode de réalisation, l'unité de contrôle est reliée au câble par l'intermédiaire de condensateurs de liaison.

Un autre mode de réalisation prévoit un procédé de détection de l'usure d'un câble comportant : une âme adaptée à transporter au moins un signal électrique utile ; une gaine entourant l'âme ; au moins un brin conducteur de détection d'usure noyé dans la gaine et s'étendant sensiblement sur toute la longueur du câble ; et au moins un élément conducteur de référence non connecté au brin de détection d'usure et s'étendant sensiblement sur toute la longueur du câble, ce procédé comprenant une étape de mesure de la capacité ou de la résistance formée entre le brin et l'élément conducteur de référence.

Selon un mode de réalisation, l'étape de mesure est mise en oeuvre par une unité de contrôle reliée au brin de détection d'usure et à l'élément conducteur de référence uniquement à l'une des extrémités du câble.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A représente schématiquement un exemple d'un mode de réalisation d'un système comportant un câble électrique et une unité de contrôle, ce système étant adapté à détecter un début d'usure du câble ;
la figure 1B est une vue en section transversale agrandie du câble électrique de la figure 1A ;
la figure 2 est une vue de côté partielle d'un câble électrique, illustrant schématiquement une variante de réalisation du système des figures 1A et 1B ; et
la figure 3 est une vue en section transversale d'un câble électrique, illustrant schématiquement une autre variante de réalisation du système des figures 1A et 1B.

Par souci de clarté, de mêmes éléments ont été désignés par de mêmes références aux différentes figures et, de plus, les diverses figures ne sont pas tracées à l'échelle.

### Description détaillée

Dans la suite de la présente description, sauf indication contraire, les termes "de l'ordre de", "approximativement", "sensiblement" et "environ" signifient à dix pourcents près.

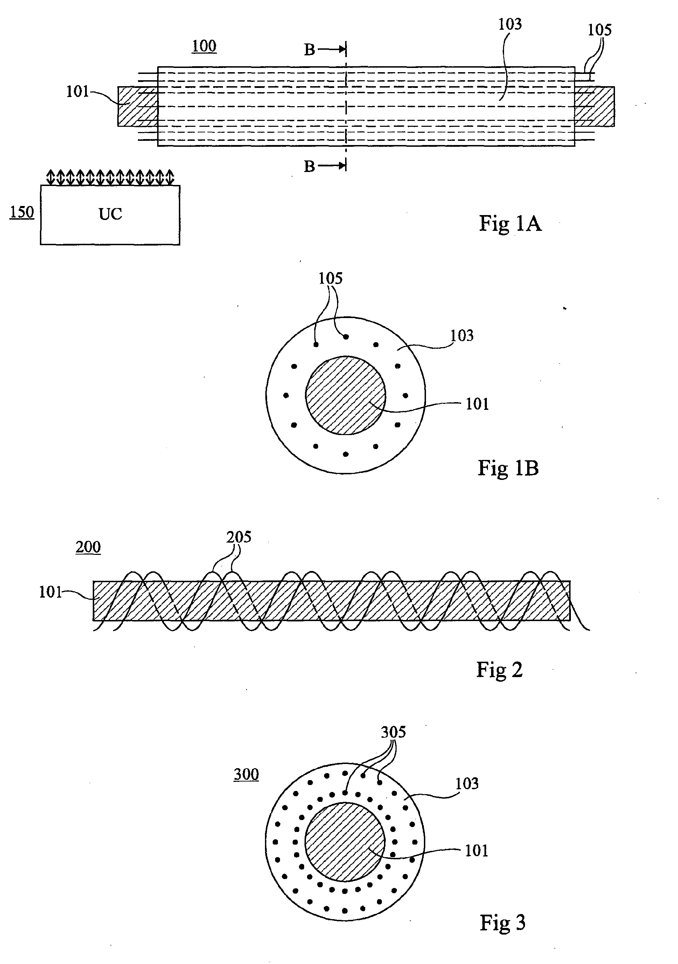

La figure 1A représente schématiquement un exemple d'un mode de réalisation d'un système permettant de contrôler l'état d'usure d'un câble électrique 100. Ce système comprend le câble 100 à surveiller, et, reliée au câble 100, une unité de contrôle 150 (UC) de l'état d'usure du câble 100. La figure 1B est une vue en section transversale agrandie du câble 100 (vue en coupe selon le plan B-B de la figure 1A).

Le câble 100 comprend une âme 101 destinée à transporter des signaux électriques utiles, par exemple des signaux de données ou des signaux d'alimentation. L'âme 101 du câble 100 peut comprendre un unique brin métallique, ou une pluralité de brins métalliques isolés les uns des autres permettant de transporter en parallèle des signaux utiles distincts.

Le câble 100 comprend en outre, autour de l'âme 101, une gaine 103 en un matériau électriquement isolant ou fortement résistif, par exemple du plastique, du caoutchouc, etc.

Le câble 100 comprend de plus, noyés dans la gaine 103, un ou plusieurs brins métalliques 105, ou brins de détection d'usure. Chaque brin 105 s'étend sensiblement sur toute la longueur du câble, et, dans le cas où plusieurs brins 105 distincts sont prévus, les différents brins 105 ne sont pas en contact les uns avec les autres à l'intérieur du câble. La disposition des brins 105 et la résistance mécanique des brins 105 sont choisies de façon que les brins 105 soient susceptibles de se rompre lorsque la gaine 103 atteint un degré d'usure que l'on souhaite détecter.

L'unité de contrôle 150 est reliée aux différents brins de détection d'usure 105 du câble 100, et est adaptée à vérifier l'intégrité de chaque brin 105. Lorsque l'unité de contrôle 150 détecte la rupture d'un brin 105, elle peut par exemple envoyer un signal d'alerte indiquant qu'une opération de maintenance devrait être programmée pour réparer ou remplacer le câble.

Dans l'exemple des figures 1A et 1B, le câble 100 comprend plusieurs brins 105 (douze brins dans l'exemple représenté). Dans cet exemple, chaque brin 105 est parallèle à l'âme 101 du câble, et les brins 105 sont régulièrement répartis autour de l'âme 101, sensiblement à la même distance de l'âme 101, à une profondeur intermédiaire de la gaine 103. En d'autres termes, dans cet exemple, en section transversale, comme cela apparaît sur la figure 1B, les brins 105 sont régulièrement répartis le long d'un cercle dont le centre coïncide avec le centre de l'âme 101 du câble, le rayon de ce cercle déterminant le degré d'usure maximal de la gaine 103 jugé acceptable dans l'application considérée.

D'autres dispositions des brins 105 dans la gaine 103 peuvent être prévues. La disposition des brins 105 est toutefois de préférence choisie de façon à permettre la détection d'un début d'usure du câble quelle que soit la face du câble soumise à l'usure.

Pour vérifier l'intégrité des brins 105, on pourrait prévoir une unité de contrôle connectée aux deux extrémités de chacun des brins 105, configurée pour, dans chaque brin 105, mesurer la résistance du brin en faisant circuler un courant entre les deux extrémités du brin ou en appliquant une tension entre les deux extrémités du brin. Une résistance faible indique que le brin est intègre, et une résistance élevée ou infinie indique que le brin est rompu.

Toutefois, un inconvénient de ce mode de contrôle est que l'unité de contrôle doit être connectée aux deux extrémités du câble, ce qui est peu pratique, notamment lorsque le câble est de grande longueur. De plus, ce mode de contrôle ne permet pas, en cas de rupture d'un brin, de localiser la zone de rupture.

Selon un aspect des modes de réalisation proposés, l'unité de contrôle 150, adaptée à vérifier l'intégrité de chaque brin 105 du câble 100, n'est reliée qu'à une seule des extrémités du câble.

L'unité de contrôle 150 est reliée à une extrémité de chaque brin 105 du câble, et peut en outre, optionnellement, être reliée à une extrémité d'un ou plusieurs brins utiles de l'âme 101 du câble.

L'unité de contrôle 150 peut être reliée aux brins du câble 100 (brins de détection d'usure 105 et, le cas échant, brins utiles de l'âme 101 soit directement, soit par l'intermédiaire de condensateurs de liaison (non représentés). Dans le cas d'une liaison entre l'unité de contrôle 150 et un brin utile de l'âme 101 du câble, la prévision d'un condensateur de liaison peut permettre d'éviter d'éventuels conflits entre les signaux utiles circulant sur le brin, et les signaux de contrôle générés par l'unité de contrôle 150 sur ce même brin. Dans ce cas, le condensateur de liaison peut être choisi pour présenter une impédance élevée pour les signaux utiles circulant sur le brin, et une impédance faible pour les signaux de contrôle générés par l'unité de contrôle 150. Dans le cas d'une liaison entre l'unité de contrôle 150 et un brin 105 de détection d'usure du câble, la prévision d'un condensateur de liaison peut permettre de prévenir d'éventuelles dégradations ou d'éventuels disfonctionnements en cas de mise en contact accidentelle du brin 105 avec un brin utile de l'âme 101 du câble, ou avec un conducteur extérieur au câble, par exemple un conducteur d'un autre câble.

A titre d'exemple, l'unité de contrôle 150 peut comprendre un microcontrôleur dont des bornes d'entrée/sortie sont reliées aux brins 105 et, le cas échéant, à un ou plusieurs brins utiles de l'âme 101 du câble, par l'intermédiaire ou non de condensateurs de liaison.

Selon un premier mode de réalisation, le câble 100 comprend au moins deux brins de détection d'usure 105 distincts, et l'unité de contrôle 150 est reliée à chacun des brins 105 mais n'est pas reliée à l'âme 101 du câble.

Dans ce premier mode de réalisation, on prévoit, lors d'une phase de vérification de l'état d'usure du câble, de mesurer à l'aide de l'unité de contrôle 150, pour chaque brin 105, la capacité formée entre le brin 105 et un conducteur de référence formé par un ou plusieurs autres brins 105 mis au même potentiel par l'unité de contrôle 150.

A titre d'exemple, le conducteur de référence peut être un unique brin 105 voisin du brin en cours de vérification, ou deux brins 105 encadrant le brin en cours de vérification, ou tous les brins 105 sauf le brin en cours de vérification, ou encore toute autre sélection d'un ou plusieurs brins 105 autres que le brin en cours de vérification. L'unité de contrôle 150 peut vérifier successivement l'intégrité de chaque brin 105, en reconfigurant, à chaque vérification, la sélection du brin 105 à vérifier et du ou des brins 105 formant le conducteur de référence.

La capacité formée entre le brin 105 en cours de vérification et le conducteur de référence est proportionnelle à la longueur (intègre) du brin en cours de vérification. Connaissant la capacité linéique de chaque brin 105 par rapport à l'élément conducteur de référence auquel il est associé, on peut déterminer, pour chaque brin 105, si le brin a été rompu et à quelle distance de l'unité de contrôle 150 la rupture a eu lieu. Ainsi, lorsque l'unité de contrôle 150 détecte la rupture d'un brin 105, elle peut envoyer un signal d'alerte indiquant non seulement que le brin est rompu, mais aussi à quelle distance de l'unité de contrôle la rupture se trouve.

A titre d'exemple, pour mesurer la capacité formée entre un brin 105 et son conducteur de référence, on peut appliquer un signal alternatif, par exemple carré, sinusoïdal ou autre, entre le brin 105 et le conducteur de référence, et mesurer l'impédance, pour ce signal, du dipôle capacitif formé entre le brin 105 et le conducteur de référence. Cette impédance est proportionnelle à 1/Cω, où C est la capacité formée entre le brin 105 et le conducteur de référence, et ω est la pulsation du signal appliqué. Connaissant les caractéristiques du signal appliqué, on peut donc déduire de la mesure d'impédance la valeur de la capacité C. A titre de variante, pour améliorer la fiabilité de la détection d'usure, on peut effectuer des recoupements en mesurant la capacité C à plusieurs fréquences différentes. Plus généralement, toute autre méthode de mesure de capacité connue peut être utilisée pour mesurer la capacité C.

Selon un deuxième mode de réalisation, le câble 100 comprend un ou plusieurs brins 105, et l'unité de contrôle 150 est reliée non seulement à chaque brin 105 du câble, mais aussi à au moins un brin conducteur de l'âme 101 du câble, destiné à transporter des signaux utiles.

Dans ce deuxième mode de réalisation, on prévoit, lors d'une phase de vérification de l'état d'usure du câble, de mesurer à l'aide de l'unité de contrôle 150, pour chaque brin 105, la capacité formée entre le brin 105 et un conducteur de référence formé par un ou plusieurs brins utiles de l'âme 101 du câble.

La capacité formée entre le brin 105 en cours de vérification et le conducteur de référence est proportionnelle à la longueur (intègre) du brin en cours de vérification. Connaissant la capacité linéique de chaque brin 105 par rapport au conducteur de référence, on peut déterminer, pour chaque brin 105, si le brin a été rompu et à quelle distance de l'unité de contrôle 150 la rupture a eu lieu.

La mesure de capacité peut être effectuée de façon similaire ou identique à ce qui a été décrit dans le premier mode de réalisation. Dans le cas où la mesure comprend l'application d'un signal alternatif entre le brin 105 en cours de vérification et le conducteur de référence, la fréquence de ce signal est de préférence choisie relativement élevée par rapport à la fréquence des signaux utiles susceptibles d'être transportés par le conducteur de référence, de façon à ne pas perturber ces signaux utiles. A titre d'exemple, si la fréquence des signaux utiles susceptibles d'être transportés dans l'âme du câble ne dépasse pas 1 kHz, on peut prévoir de réaliser la mesure de capacité à une fréquence supérieure ou égale à 100 kHz, par exemple de l'ordre de 1 MHz.

Selon un troisième mode de réalisation, la gaine 103 du câble 100 n'est pas totalement isolante mais est en un matériau résistif adapté à laisser circuler une certaine quantité de courant, par exemple un caoutchouc présentant des fuites tel qu'un caoutchouc poreux. Dans ce troisième mode de réalisation, le câble 100 comprend au moins deux brins de détection d'usure 105 distincts, et l'unité de contrôle 150 est reliée à chacun des brins 105 mais n'est pas reliée à l'âme 101 du câble.

Dans ce troisième mode de réalisation, on prévoit, lors d'une phase de vérification de l'état d'usure du câble, de mesurer à l'aide de l'unité de contrôle 150, pour chaque brin 105, la résistance entre le brin 105 et un conducteur de référence formé par un ou plusieurs autres brins 105 mis au même potentiel par l'unité de contrôle 150.

A titre d'exemple, le conducteur de référence peut être un brin 105 voisin du brin en cours de vérification, ou deux brins 105 encadrant le brin en cours de vérification, ou tous les brins 105 sauf le brin en cours de vérification, ou encore toute autre sélection d'un ou plusieurs brins 105 autres que le brin en cours de vérification.

La résistance formée entre le brin 105 en cours de vérification et le conducteur de référence est inversement proportionnelle à la longueur (intègre) du brin en cours de vérification. Connaissant la résistance linéique du dipôle résistif formé entre chaque brin 105 et l'élément conducteur de référence qui lui est associé, on peut déterminer, pour chaque brin 105, si le brin a été rompu et à quelle distance de l'unité de contrôle 150 la rupture a eu lieu.

Selon un quatrième mode de réalisation, le câble 100 comprend un ou plusieurs brins 105, et l'unité de contrôle 150 est reliée non seulement à chaque brin 105 du câble, mais aussi à au moins un brin conducteur de l'âme 101 du câble, destiné à transporter des signaux utiles.

Dans ce quatrième mode de réalisation, on prévoit, lors d'une phase de vérification de l'état d'usure du câble, de mesurer à l'aide de l'unité de contrôle 150, pour chaque brin 105, la résistance formée entre le brin 105 et un conducteur de référence formé par un ou plusieurs brins utiles de l'âme 101 du câble.

La résistance formée entre le brin 105 en cours de vérification et le conducteur de référence est inversement proportionnelle à la longueur (intègre) du brin en cours de vérification. Connaissant la résistance linéique du dipôle résistif formé entre le brin 105 et l'élément conducteur de référence, on peut déterminer si le brin a été rompu et à quelle distance de l'unité de contrôle 150 la rupture a eu lieu.

On notera que le matériau de la gaine 103 peut être à la fois diélectrique et résistif. Dans ce cas, des mesures de résistance et de capacité peuvent être effectuées, et recoupées pour améliorer la précision du contrôle d'usure du câble. Plus généralement, pour améliorer la précision du contrôle d'usure du câble, on peut prévoir de combiner en tout ou partie les premier, deuxième, troisième et/ou quatrième modes de réalisation susmentionnés.

Lors des contrôles d'intégrité des brins 105 du câble 100, les signaux de mesure de résistance ou de capacité générés par l'unité de contrôle 150 sont de préférence choisis de façon à ne pas perturber les équipements environnants et respecter les règles de compatibilité électromagnétiques. Si nécessaire, en fonction de la sensibilité de l'environnement aux perturbations électromagnétiques, les mesures peuvent être effectuées au moyen de signaux large bande de faible amplitude.

On notera que les modes de réalisation proposés ne se limitent pas à l'exemple des figures 1A et 1B, dans lequel les brins de détection d'usure 105 prévus dans la gaine 103 sont parallèles à l'âme 101 du câble. De nombreuses autres formes et/ou dispositions des brins de détection d'usure peuvent être prévues. A titre d'exemple, les brins de détection d'usure peuvent avoir une forme en zigzags ou en créneaux, chaque brin pouvant être disposé soit dans un plan radial du câble soit dans un autre plan. Dans ce cas, les brins de détection d'usure présentent une longueur totale (développée) supérieure à la longueur du câble, et forment donc, avec les éléments conducteurs de référence correspondants, des capacités (respectivement des résistances) supérieures (respectivement inférieures) à celles de l'exemple des figures 1A et 1B. Les détections de rupture des brins en mode capacitif (premier et deuxième modes de réalisation) et en mode résistif (troisième et quatrième modes de réalisation) s'en trouvent facilitées.

La figure 2 est une vue de côté partielle d'un câble électrique 200, illustrant schématiquement un autre exemple de disposition des brins de détection d'usure compatible avec les modes de réalisation décrits ci-dessus.

Le câble 200 comprend, comme dans l'exemple des figures 1A et 1B, une âme 101 destinée à transporter des signaux électrique utiles, et une gaine 103 (non représentée sur la figure 2 pour plus de clarté) entourant l'âme 101. Le câble 200 comprend de plus, noyés dans la gaine 103, un ou plusieurs brins métalliques 205 de détection d'usure.

Dans l'exemple de la figure 2, les brins 205 sont torsadés, chaque brin 205 formant un enroulement autour de l'âme 101 du câble, cet enroulement s'étendant sensiblement sur toute la longueur du câble. Dans l'exemple représenté, deux brins 205 distincts sensiblement parallèles entre eux ont été représentés. Toutefois, le câble 200 pourrait comprendre un unique brin torsadé 205 ou un nombre de brins torsadés 205 supérieur à deux. Dans le cas où plusieurs brins 205 sont prévus, les brins 205 sont disposés de façon que deux brins 205 distincts ne soient pas en contact à l'intérieur du câble.

Dans l'exemple représenté, les brins 205 sont tous torsadés selon le même sens d'enroulement autour de l'âme 101 du câble. Les modes de réalisation décrits ne se limitent toutefois pas à ce cas particulier, et on pourra prévoir que des brins de détection d'usure 205 distincts soient enroulés autour de l'âme 101 du câble selon des directions d'enroulement opposées. Dans ce cas, les brins enroulés selon des directions distinctes peuvent être disposés à des profondeurs distinctes de la gaine, pour éviter la mise en contact de ces brins à l'intérieur du câble.

Un avantage de la variante de réalisation de la figure 2 est que, pour une longueur de câble donnée, la longueur des brins de détection d'usure 205 est supérieure à la longueur des brins de détection d'usure 105 dans l'exemple des figures 1A et 1B. Ceci facilite la détection de variations de capacité ou de résistance entre chaque brin de détection d'usure et le conducteur de référence qui lui est associé et augmente donc la fiabilité du système de détection d'usure.

Un autre avantage de la variante de réalisation de la figure 2 est que la disposition en torsades des brins de détection d'usure 205 renforce la tenue mécanique du câble par rapport à l'exemple des figures 1A et 1B, en facilitant la flexion du câble.

La figure 3 est une vue en coupe en section transversale d'un câble électrique 300, illustrant schématiquement un autre exemple de disposition des brins de détection d'usure compatible avec les modes de réalisation décrits en relation avec les figures 1A et 1B.

Le câble 300 comprend, comme dans l'exemple des figures 1A et 1B, une âme 101 destinée à transporter des signaux électrique utiles, et une gaine 103 entourant l'âme 101. Le câble 300 comprend de plus, noyés dans la gaine 103, plusieurs brins métalliques 305 de détection d'usure.

Dans l'exemple de la figure 3, comme dans les exemples des figures 1A et 1B, chaque brin 305 est sensiblement parallèle à l'âme 101 du câble, s'étend sensiblement sur toute la longueur du câble, et n'est en contact avec aucun autre brin 305 à l'intérieur du câble. Le câble 300 diffère du câble 100 des figures 1A et 1B en ce que, dans le câble 300, les brins de détection d'usure 305 ne sont pas tous à la même distance de l'âme 101 du câble, mais sont placés à au moins deux profondeurs distinctes dans la gaine 103. Dans l'exemple représenté, les brins 305 sont, en section transversale, répartis dans la gaine 103 sur deux cercles de rayons distincts dont les centres coïncident avec le centre de l'âme 101.

Un avantage de la variante de réalisation de la figure 3 est qu'elle permet de détecter et de différentier deux stades d'usure distincts, ce qui offre une plus grande flexibilité pour la gestion des opérations de maintenance des câbles.

Plus généralement, quelle que soit la forme (torsadée, zigzag, rectiligne, ou autre) des brins de détection d'usure disposés dans la gaine 103 du câble, on peut prévoir de disposer des brins de détection d'usure à plusieurs profondeurs distinctes dans la gaine (deux ou plus), pour permettre la différentiation de degrés d'usure distincts.

Des modes de réalisation particuliers ont été décrits. Diverses variantes et modifications apparaîtront à l'homme de l'art.

En particulier, bien que cela n'ait pas été représenté sur les figures, les modes de réalisation décrits ci-dessus sont aussi compatibles avec des câbles de type coaxial, c'est-à-dire comportant :
- une âme comportant un ou plusieurs brins conducteurs utiles.entourés d'une première gaine isolante ou résistive ; et
- une couche conductrice entourant la première gaine, cette couche conductrice étant elle-même entourée d'une deuxième gaine isolante ou résistive.

Dans ce cas, les brins de détection d'usure sont de préférence placés dans la deuxième gaine (gaine extérieure), de façon à pouvoir détecter l'usure du câble avant que la couche conductrice intermédiaire ne soit attaquée. Toutefois, à titre de variante, si la couche conductrice intermédiaire n'a pas de fonction électrique critique, par exemple si elle n'a qu'une fonction de tenue mécanique du câble, on peut prévoir de placer les brins de détection d'usure dans la première gaine (gaine intérieure).

On notera que dans le cas d'un câble coaxial, l'élément conducteur de référence peut être la couche conductrice intermédiaire du câble.

## Revendications

1. Système comprenant :
un câble (100 ; 200 ; 300) comportant : une âme (101) adaptée à transporter au moins un signal électrique utile ; une gaine (103) entourant ladite âme ; au moins un brin conducteur de détection d'usure (105 ; 205 ; 305) noyé dans la gaine et s'étendant sensiblement sur toute la longueur du câble ; et au moins un élément conducteur de référence non connecté audit au moins un brin de détection d'usure et s'étendant sensiblement sur toute la longueur du câble ; et
une unité de contrôle (150) adaptée à mesurer la capacité ou la résistance formée entre ledit au moins un brin (105 ; 205 ; 305) et ledit au moins un élément conducteur de référence.

2. Système selon la revendication 1, dans lequel, l'unité de contrôle (150) est reliée audit au moins un brin de détection d'usure (105 ; 205 ; 305) et audit au moins un élément conducteur de référence uniquement à l'une des extrémités du câble (100 ; 200 ; 300).

3. Système selon la revendication 1 ou 2, dans lequel l'unité de contrôle (150) est adaptée à déduire de ladite mesure de capacité ou de résistance la présence ou l'absence d'une rupture dudit au moins un brin de détection d'usure (105 ; 205 ; 305).

4. Système selon la revendication 3, dans lequel l'unité de contrôle (150) est en outre adaptée à déduire de ladite mesure la localisation de ladite rupture par rapport à l'unité de contrôle (150).

5. Système selon l'une quelconque des revendications 1 à 4, dans lequel le câble (100 ; 200 ; 300) comprend plusieurs brins conducteurs de détection d'usure (105 ; 205 ; 305) noyés dans la gaine (103), et dans lequel ledit élément conducteur de référence comprend un ou plusieurs desdits brins de détection d'usure.

6. Système selon l'une quelconque des revendications 1 à 5, dans lequel l'âme (101) du câble (100 ; 200 ; 300) comprend un ou plusieurs brins conducteurs adaptés à transporter des signaux électriques utiles, et dans lequel ledit élément conducteur de référence comprend un ou plusieurs desdits brins de l'âme (101) du câble.

7. Système selon l'une quelconque des revendications 1 à 6, dans lequel ledit au moins un brin de détection d'usure (105 ; 305) est sensiblement parallèle à l'âme (101) du câble (100 ; 300).

8. Système selon l'une quelconque des revendications 1 à 6, dans lequel ledit au moins un brin de détection d'usure (205) est torsadé autour de l'âme (101) du câble (200).

9. Système selon l'une quelconque des revendications 1 à 8, dans lequel le câble (300) comprend plusieurs brins de détection d'usure (305) disposés à plusieurs profondeurs distinctes dans la gaine (103).

10. Système selon l'une quelconque des revendications 1 à 9, dans lequel l'unité de contrôle (150) comprend un microcontrôleur.

11. Système selon l'une quelconque des revendications 1 à 10, dans lequel l'unité de contrôle (150) est reliée au câble (100 ; 200 ; 300) par l'intermédiaire de condensateurs de liaison.

12. Procédé de détection de l'usure d'un câble (100 ; 200 ; 300) comportant : une âme (101) adaptée à transporter au moins un signal électrique utile ; une gaine (103) entourant ladite âme ; au moins un brin conducteur de détection d'usure (105 ; 205 ; 305) noyé dans la gaine et s'étendant sensiblement sur toute la longueur du câble ; et au moins un élément conducteur de référence non connecté audit au moins un brin de détection d'usure et s'étendant sensiblement sur toute la longueur du câble, ce procédé comprenant une étape de mesure de la capacité ou de la résistance formée entre ledit au moins un brin (105 ; 205 ; 305) et ledit au moins un élément conducteur de référence.

13. Procédé selon la revendication 12, dans lequel ladite étape de mesure est mise en oeuvre par une unité de contrôle (150) reliée audit au moins un brin de détection d'usure (105 ; 205 ; 305) et audit au moins un élément conducteur de référence uniquement à l'une des extrémités du câble (100 ; 200 ; 300).

## Patentansprüche

1. Ein System, welches folgendes aufweist:
ein Kabel (100; 200; 300), welches aufweist: einen Kern (101), der in Lage ist, mindestens ein nützliches elektrisches Signal zu transportieren; eine Hülle (103), die den Kern umgibt; mindestens einen leitenden Abnutzungsdetektionsstrang (105; 205; 305) eingebettet in die Hülle und
sich im Wesentlichen entlang der gesamten Länge des Kabels erstreckend; und mindestens ein leitendes Referenzelement, welches nicht mit dem erwähnten mindestens einen Abnutzungsdetektionsstrang verbunden ist, und sich im Wesentlichen entlang der gesamten Länge des Kabels erstreckt; und
eine Steuereinheit (150), die in der Lage ist die Kapazität oder den Widerstand gebildet zwischen dem Abnutzungsdetektionsstrang (105; 205; 305) und dem leitenden Referenzelement zu messen.

2. Das System nach Anspruch 1, wobei die Steuereinheit (150) mit dem erwähnten mindestens einen Abnutzungsdetektionsstrang (105; 205; 305) und mit dem mindestens einen leitenden Referenzelement nur an einem der Enden des Kabels (100; 200; 300) verbunden ist.

3. Das System nach Anspruch 1 oder 2, wobei die Steuereinheit (150) in der Lage ist aus der Kapazitäts- oder Widerstands-Messung auf das Vorhandensein oder das Nicht-Vorhandensein eines Bruchs von dem erwähnten mindestens einen Abnutzungsdetektionsstrang (105; 205; 305) zu schließen.

4. Das System nach Anspruch 3, wobei die Steuereinheit (150) ferner in der Lage ist aus der Messung den Ort des Bruchs bezüglich der Steuereinheit (150) abzuleiten.

5. Das System nach einem der Ansprüche 1 bis 4, wobei das Kabel (100; 200; 300) eine Vielzahl von leitenden Abnutzungsdetektionssträngen (105; 205; 305) eingebettet in die Hülle (103) aufweist, und wobei das leitende Referenzelement einen oder eine Vielzahl der Abnutzungsdetektionsstränge aufweist.

6. Das System nach einem der Ansprüche 1 bis 5, wobei der Kern (101) des Kabels (100; 200; 300) einen oder eine Vielzahl von leitenden Strängen aufweist, die in der Lage sind, nützliche elektrische Signale zu übertragen, und wobei das leitende Referenzelement einen oder eine Vielzahl der erwähnten Stränge des Kerns (101) des Kabels aufweist.

7. Das System nach einem der Ansprüche 1 bis 6, wobei der erwähnte mindestens eine Abnutzungsdetektionsstrang (105; 305) im Wesentlichen parallel zum Kern (101) des Kabels (100; 300) verläuft.

8. Das System nach einem der Ansprüche 1 bis 6, wobei der mindestens eine Abnutzungsdetektionsstrang (205) um den Kern (101) des Kabels (200) gewickelt ist.

9. Das System nach einem der Ansprüche 1 bis 8, wobei das Kabel (300) eine Vielzahl von Abnutzungsdetektionssträngen (305) aufweist, und zwar angeordnet in einer Vielzahl von unterschiedlichen Tiefen der Hülle (103).

10. Das System nach einem der Ansprüche 1 bis 9, wobei die Steuereinheit (150) einen Mikrocontroller aufweist.

11. Das System nach einem der Ansprüche 1 bis 10, wobei die Steuereinheit (150) mit dem Kabel (100; 200; 300) über Verbindungskondensatoren verbunden ist.

12. Ein Verfahren zum Detektieren der Abnutzung eines Kabels (100; 200; 300), welches folgendes aufweist:
einen Kern (101), der in Lage ist, mindestens ein nützliches elektrisches Signal zu transportieren; eine Hülle (103), die den Kern umgibt;
mindestens einen leitenden Abnutzungsdetektionsstrang (105; 205; 305) eingebettet in die Hülle und sich im Wesentlichen entlang der gesamten Länge des Kabels erstreckend; und mindestens ein leitendes Referenzelement, welches nicht mit dem erwähnten mindestens einen Abnutzungsdetektionsstrang verbunden ist, und sich im Wesentlichen entlang der gesamten Kabellänge erstreckt; wobei das Verfahren einen Schritt des Messens der Kapazität oder des Widerstandes geformt zwischen dem mindestens einen Strang (105; 205; 305) und dem mindestens einen leitenden Referenzelement aufweist.

13. Das Verfahren nach Anspruch 12, wobei der Messschritt durch eine Steuereinheit (150) implementiert ist, die verbunden ist mit mindestens einem Abnutzungsdetektionsstrang (105; 205; 305) und mit dem erwähnten mindestens einen leitenden Referenzelement und zwar nur an einem der Enden des Kabels (100; 200; 300).

## Claims

1. A system comprising:
a cable (100; 200; 300) comprising: a core (101) capable of transporting at least one useful electric signal; a sheath (103) surrounding said core; at least one conductive wear detection strand (105; 205; 305) embedded in the sheath and substantially extending along the entire length of the cable; and at least one reference conductive element which is not connected to said at least one wear detection strand and substantially extends along the entire cable length; and
a control unit (150) capable of measuring the capacitance or the resistance formed between the wear detection strand (105; 205; 305) and the reference conductive element.

2. The system of claim 1, wherein the control unit (150) is connected to said at least one wear detection strand (105; 205; 305) and to said at least one reference conductive element only at one of the ends of the cable (100; 200; 300).

3. The system of claim 1 or 2, wherein the control unit (150) is capable of deducing from said capacitance or resistance measurement the presence or the absence of a breakage of said at least one wear detection strand (105; 205; 305).

4. The system of claim 3, wherein the control unit (150) is further capable of deducing from said measurement the location of said breakage with respect to the control unit (150).

5. The system of any of claims 1 to 4, wherein the cable (100; 200; 300) comprises a plurality of conductive wear detection strands (105; 205; 305) embedded in the sheath (103), and wherein said reference conductive element comprises one or a plurality of said wear detection strands.

6. The system of any of claims 1 to 5, wherein the core (101) of the cable (100; 200; 300) comprises one or a plurality of conductive strands capable of transporting useful electric signals, and wherein said reference conductive element comprises one or a plurality of said strands of the core (101) of the cable.

7. The system of any of claims 1 to 6, wherein said at least one wear detection strand (105; 305) is substantially parallel to the core (101) of the cable (100; 300).

8. The system of any of claims 1 to 6, wherein said at least one wear detections strand (205) is twisted around the core (101) of the cable (200).

9. The system of any of claims 1 to 8, wherein the cable (300) comprises a plurality of wear detection strands (305) arranged at a plurality of different depths in the sheath (103).

10. The system of any of claims 1 to 9, wherein the control unit (150) comprises a microcontroller.

11. The system of any of claims 1 to 10, wherein the control unit (150) is connected to the cable (100; 200; 300) via connection capacitors.

12. A method of detecting the wearing of a cable (100; 200; 300) comprising: a core (101) capable of transporting at least one useful electric signal; a sheath (103) surrounding said core; at least one conductive wear detection strand (105; 205; 305) embedded in the sheath and substantially extending along the entire length of the cable; and at least one reference conductive element which is not connected to said at least one wear detection strand and substantially extends along the entire cable length, the method comprising a step of measuring the capacitance or the resistance formed between said at least one strand (105; 205; 305) and said at least one reference conductive element.

13. The method of claim 12, wherein the measurement step is implemented by a control unit (150) connected to said at least one wear detection strand (105; 205; 305) and to said at least one reference conductive element only at one of the ends of the cable (100; 200; 300).
